# DEMANDE DE BREVET EUROPEEN

(11) **EP 0 666 604 A1**
(43) Date de publication de la demande: **09.08.1995**
(21) Numéro de dépôt: 95400192.1
(22) Date de dépôt: 30.01.1995
(51) Int. Cl.: H01L 33/00, H01L 31/0352, H01S 3/025

(54) **Procédé pour la réalisation d'un composant électro-optique et/ou photonique**

(30) Priorité: 31.01.1994 FR 9401011
(71) Demandeur: FRANCE TELECOM, F-75015 Paris (FR)
(72) Inventeur: Krauz, Philippe, F-94000 Creteil (FR); Rao, Elchuri Krishna, F-92130 Issy les Moulinaux (FR)
(74) Mandataire: Martin, Jean-Jacques

(57) **Abrégé**

Procédé pour la réalisation d'un composant présentant au moins une fonction électro-optique et/ou photonique intégrée, dans lequel on dépose au moins une couche de SiOx dopée (3) sur une couche à puits quantiques (2) à base de matériaux III/V et on traite thermiquement l'échantillon ainsi obtenu ; on choisit l'épaisseur de ladite couche (3), la nature de l'élément dopant (isoélectronique activant ou bloquant et/ou électroniquement actif de type n ou p) et la concentration de son dopage, ainsi que les conditions du traitement thermique, de façon à conférer au composant les propriétés électro-optiques et/ou photoniques souhaitées.

## Description

La présente invention est relative à un procédé pour la réalisation de composants à fonction(s) électro-optique(s) et/ou photonique(s), à partir d'hétérostructures à puits quantiques à base de matériaux III/V, tels que GaAs et InP.

On sait qu'il est possible de modifier localement, avec ou sans l'introduction de porteurs libres, les énergies de bande interdite et l'indice de réfraction de telles hétérostructures par des techniques d'interdiffusion ou de désordre d'alliage. Ces modifications d'énergies de bande interdite et d'indice de réfraction induisent des modifications des propriétés électro-optiques des hétérostructures, et permettent l'élaboration de différentes fonctions électro-optiques et/ou photoniques actives (laser, modulateur, etc.) ou passives (guide d'ondes, coupleur directionnel, etc.).

Parmi les techniques principalement utilisées à ce jour, on peut citer les techniques de diffusion thermique ou d'implantation ionique, ainsi que les techniques par dépôts de couches diélectriques.

Dans la technique de diffusion thermique, on réalise le désordre ou la transformation des propriétés opto-électroniques de l'hétérostructure par l'introduction d'un élément électriquement actif de tyne n comme le silicium (Si) ou le soufre (S), ou de type P comme le zinc (Zn) pour exemples. L'introduction est obtenue après un traitement thermique qui induit la diffusion de l'élément soit déposé directement sur la surface, ou soit qui se trouve en phase vapeur en contact avec cette surface à la température du traitement thermique. Pour des exemples d'applications de cette technique, on pourra avantageusement se référer aux différentes publications suivantes:
* Low-threshold InGaAs/GaAs/AlGaAs quantum-well laser with an intracavity optical modulator by impurity-induced disordering; W.X. ZOU et al, Applied Physics Letters, 62 (6), 1993, pp 556-558.
* Impurity-induced Layer Disordering in In(AlGa)P-InGaP Quantum-well Heterostructures: Visible-spectrum-buried Heterostructure Lasers; J. M. DALLESASSE et al, Journal of Applied Physics Letters, 66 (2), 1989, pp 482-487;
* GaAlAs buried multiquantum well lasers fabricated by diffusion-induced disorderingby ; Tadashi Fukuzawa, Shigeru Semura, Hiroshi Saito, Tsuneaki Ohta, Yoko Uchida, and Hisao Nakashima ; Appl. Phys. Lett. 45(1), 1 July 1984, pp. 1-3 ;
* Fabrication of GaAlAs 'Window-stripe' multi-quantum-well heterostructure lasers utilising Zn diffusion-induced alloying ; Y. SUZUKI, Y. HORIKOSHI, M KOBAYASHI, H. OKAMOTO - Electronics Letters, 26th April 1984, Vol. 20 No. 9, pp. 383-384.

Cette technique présente néanmoins l'inconvénient de n'être utilisable que dans les cas où l'on cherche à obtenir des régions transformées dopées électriquement, donc avec la présence de porteurs libres de type n ou de type p.

On notera en particulier que dans l'article de J. M. DALLESASSE et al. précité, la couche qui est déposée sur la structure à puits quantiques est une couche de Si et non une couche de Si02 dopé. La couche de Si02 dopé qui est mentionnée est une couche qui encapsule l'échantillon constitué par la couche à puits quantiques et la couche de Si.

La couche de SiO2 dopé n'intervient donc pas directement dans la modification des niveaux d'énergie de l'hétérostructure à puits quantiques ; c'est la diffusion de Si dans l'hétérostructure qui est à l'origine du désordre et de la transformation des propriétés opto-électroniques de celle-ci.

La diffusion du silicium introduit des porteurs libres dans la région désordonnée ou modifiée.

Dans la technique d'implantation ionique, on dispose sur la surface de l'hétérostructure un masque, pour définir les régions à modifier localement, et l'on bombarde par des ions à implanter. On fait ensuite subir à l'hétérostructure un traitement thermique.

On pourra avantageusement se référer à cet égard aux deux publications suivantes :
* Quantum-Well Laser with Integrated Passive Waveguide Fabrication by Neutral Imputity Disordering; S.R. ANDREW et al, IEEE Photonics Technology Letters, vol. 4, No. 5, 1992, pp 426-428.
* Large blueshifting of InGaAs/InP quantum-well band gaps by ion implantation, J.E. ZUCKER et al, Applied Physics Letters, 60 (4), 1992, pp 3036-3038.

Bien que l'implantation ionique permette de réaliser la transformation de l'hétérostructure avec ou sans l'introduction de porteurs libres dans la région transformée, cette technique fait apparaître dans les régions transformées de l'hétérostructure des défauts résiduels qu'il est difficile d'annihiler. Les techniques d'implantation ionique n'ont, de ce fait, jusqu'à présent été utilisées que pour la réalisation de fonctions passives.

Les techniques dites "à couches diélectriques" consistent à déposer des couches diélectriques, telles que SiOx ou Six'Ny', sur des hétérostructures à puits quantiques, puis à traiter thermiquement les échantillons ainsi obtenus pour obtenir la transformation sans l'introduction de porteurs libres. Dans le cas d'hétérostructures à puits quantiques à base de GaAs, par exemple, le traitement thermique fait exodiffusé le gallium dans le diélectrique SiOx, ce qui génère des lacunes de Ga à l'interface diélectrique-structure. La diffusion thermique de ces lacunes en profondeur conduit à la transformation de l'hétérostructure à puits quantiques.

Pour des exemples d'applications de ces techniques, on pourra avantageusement se référer aux différentes publications suivantes :
* Monolithic Waveguide Coupled Cavity Lasers and Modulators Fabricated by Impurity Induced Disordering; Robert L. THORNTON et al, Journal of Lightwave Technology, vol. 6, No. 6, 1988, pp 786-792.
* Integrated External-Cavity InGaAs/InP Lasers Using Cap-Annealing Disordering; T. MIYAZAWA et al, IEEE Photonics Technology Letters, vol. 3, No. 5, 1991, pp 421-423.
* Refractive Index Change of GalnAs/InP Disordered Superlattice Wave-guide; A. WAKATSUKI et al, IEEE Photonics Technology Letters, vol. 3, No. 10, 1991, pp 905-907.
* Monolithic Integration of an (Al)GaAs laser and an Intracavity Electroabsorption Modulateur Using Selective Partial Interdiffusion; S. O'BRIEN et al, Applied Physics Letters, 58 (13), 1991, pp 1363-1365.
* Spatial Control of Quantum Well Intermixing in GaAs/GaAlAs Using a One-step Process; S. G. AYLING et al, Electronics Letters, vol. 28, No. 24, 1992, pp 2240-2241.

Cette technique par dépôt diélectrique, du fait des contraintes à l'interface diélectrique-échantillon à hétérostructures à puits quantiques, est difficilement applicable à la réalisation reproductible de composants discrets ou intégrés à base de GaAs. Dans le cas de l'InP, elle est inapplicable de manière reproductible. Une unique réalisation est rapportée par la littérature et a été obtenue sous des conditions particulièrement rigoureuses de traitement thermique par des impulsions successives de montée rapide en température.

La présente invention propose quant à elle un procédé simple, reproductible et universel qui utilise un dépôt diélectrique du type SiOx adapté grâce à la modification de sa constitution physico-chimique.

Ceci permet de transformer ou de modifier les propriétés opto-électroniques des hétérostructures à puits quantiques à base des matériaux III-V tels que le GaAs et l'InP (sans ou avec l'introduction de porteurs libres selon les besoins de fonctionnement), pour la réalisation de différentes fonctions opto-électroniques et photoniques.

Ce procédé est en outre peu coûteux et facile à mettre en oeuvre.

La présente invention a donc pour objet un procédé pour la réalisation de composants présentant au moins une fonction électro-optique et/ou photonique intégrée, dans lequel on dépose au moins une couche diélectrique sur une couche à puits quantiques à base de matériaux III/V et on traite thermiquement l'échantillon ainsi obtenu.

Ce dépôt est caractérisé par le fait que la couche diélectrique est une couche de SiOx dopée, x étant compris dans l'intervalle ]0,2],
et par le fait que l'on choisit l'épaisseur de ladite couche, la nature et la concentration de son dopage, ainsi que les conditions du traitement thermique, de façon à décaler l'énergie de bande interdite de la région de la couche à puits quantiques sur laquelle la couche diélectrique est déposée pour conférer à cette région les propriétés électro-optiques et/ou photoniques correspondant à ladite fonction.

Le procédé selon l'invention est particulièrement éloigné de celui décrit dans l'article de J. M. DALLESASSE et al. déjà cité puisque dans le procédé proposé dans cet article, la modification des multipuits quantiques résulte de la diffusion de silicium, qui introduit de plus des porteurs libres dans la région désordonnée ou modifiée.

Avec le procédé selon l'invention, la couche à puits quantiques est interdiffusée ou modifiée sans introduction de porteurs libres.

On notera en outre que dans l'article précité, le dépôt de PSG (Phospho-Silica-Glass) ne joue aucun rôle dans le processus d'interdiffusion ou de modification. Ce dépôt est réalisé pour inhiber ou minimiser la décomposition du phosphore de la couche de surface de l'échantillon (InGaP ou InAlP).

Selon l'invention, le dopage de la silice, et par exemple le dopage au phosphore, est déterminant pour l'obtention de l'interdiffusion ou de la modification sans présence de porteurs libres.

La modification de la couche de multipuits quantiques est obtenue et contrôlée par la présence d'un dopage de phosphore, et/ou par l'épaisseur du dépôt.

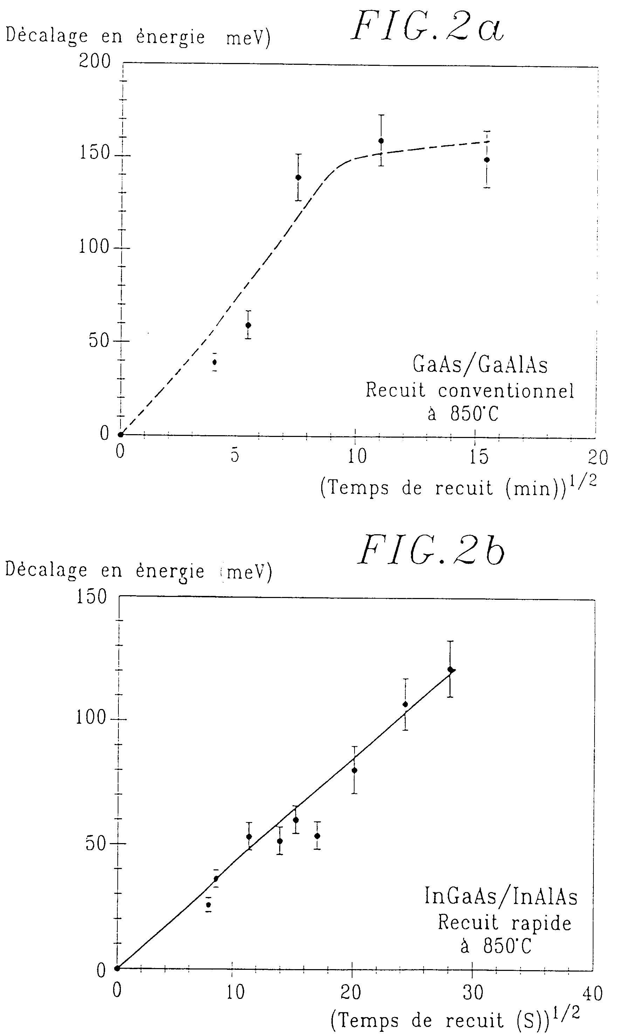

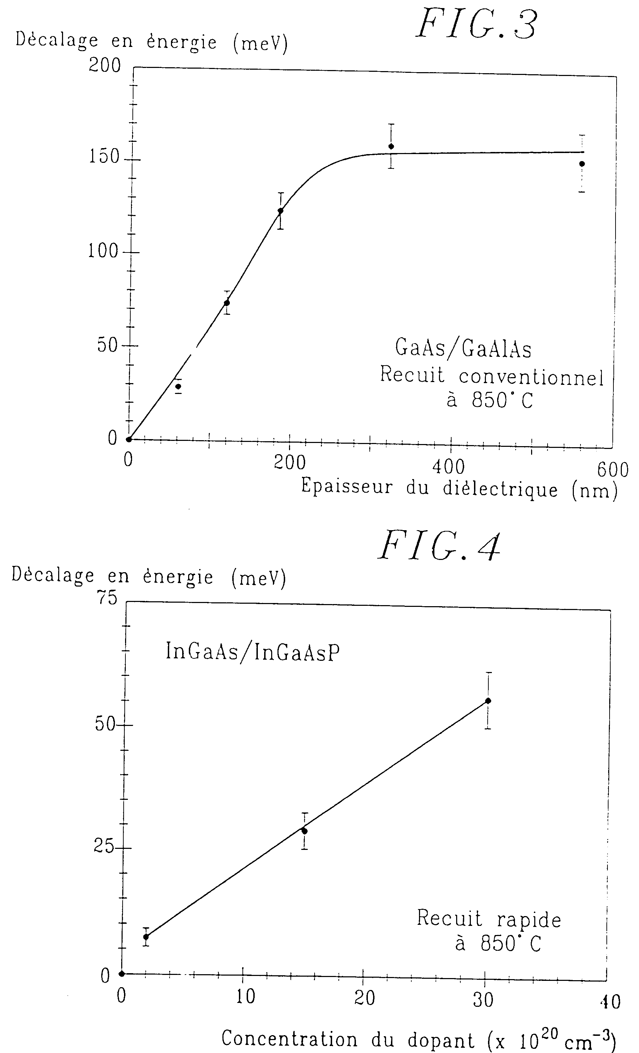

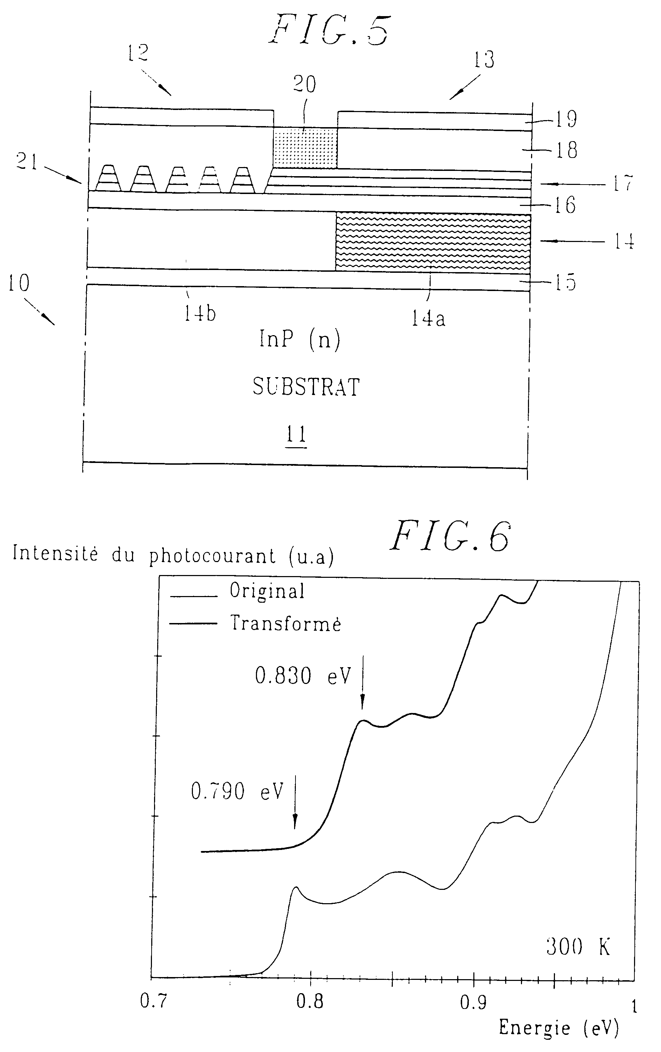

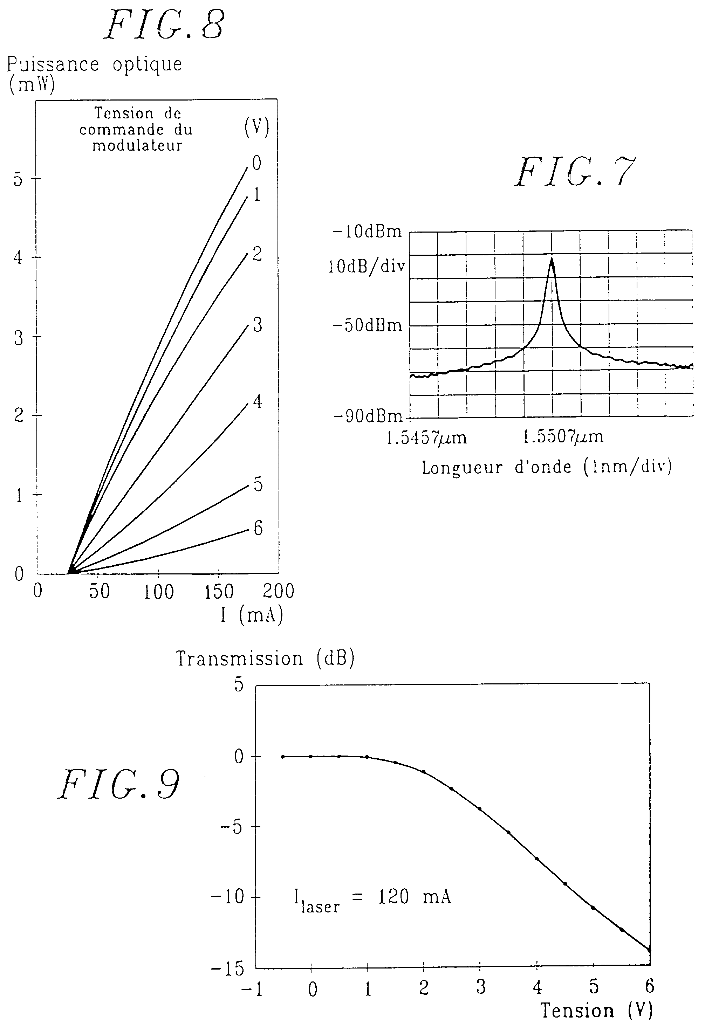

D'autres caractéristiques et avantages de ce procédé ressortiront encore de la description qui suit. Cette description est purement illustrative et non limitative. Elle doit être lue en regard des dessins annexés sur lesquels :
. les figures 1a à 1e illustrent de façon générale la mise en oeuvre du procédé conforme à l'invention ;
. les figures 2a à 2d sont des graphes représentant, en fonction de la racine carrée de la durée du traitement thermique du procédé illustré sur les figures 1a à 1e, le décalage d'énergie de bande interdite obtenu pour quatre types d'hétérostructures à puits quantiques ;
. la figure 3 est un graphe sur lequel on a porté, en fonction de l'épaisseur de diélectrique dopé déposé conformément au procédé illustré sur les figures 1a à 1e, le décalage d'énergie de bande interdite obtenu pour un type particulier d'hétérostructure ;
. la figure 4 est un graphe sur lequel on a porté, pour un autre type d'hétérostructure, en fonction de la concentration de dopant dans le diélectrique déposé, le décalage d'énergie de bande interdite obtenu ;
. la figure 5 est une représentation schématique d'un composant à fonctions laser et modulateur intégrées réalisé en mettant en oeuvre le procédé conforme à l'invention ;
. la figure 6 est un graphe sur lequel on a représenté les caractéristiques d'intensité de photocourant en fonction de l'énergie des photons incidents, du modulateur intégré du composant de la figure 5 ;
. la figure 7 représente la courbe de gain en fonction de la longueur d'onde du laser intégré ;
. la figure 8 est un graphe sur lequel ont été portées, pour différentes tensions de charge du modulateur du composant de la figure 5, les puissances optiques en sortie de ce modulateur ;
. la figure 9 est un graphe sur lequel on a porté les valeurs de transmission optique du laser-modulateur intégré du composant de la figure 5 en fonction de la tension qu'on lui applique.

L'invention s'applique de façon générale à toutes hétérostructures à puits quantiques à base de matériaux III/V, telles que des hétérostructures du type GaAs/(Ga)AlAs, InGaAs/Ga(Al)As sur substrats GaAs, et InGaAs/InP, InGaAs/InGaAsP, (InGaAsP)1/(InGaAsP)2, InGaAs/In(Ga)AlAs sur substrat InP.

Sur les figures 1a à 1e, on a référencé par 1 le substrat d'une telle hétérostructure, et par 2 ses couches à puits quantiques.

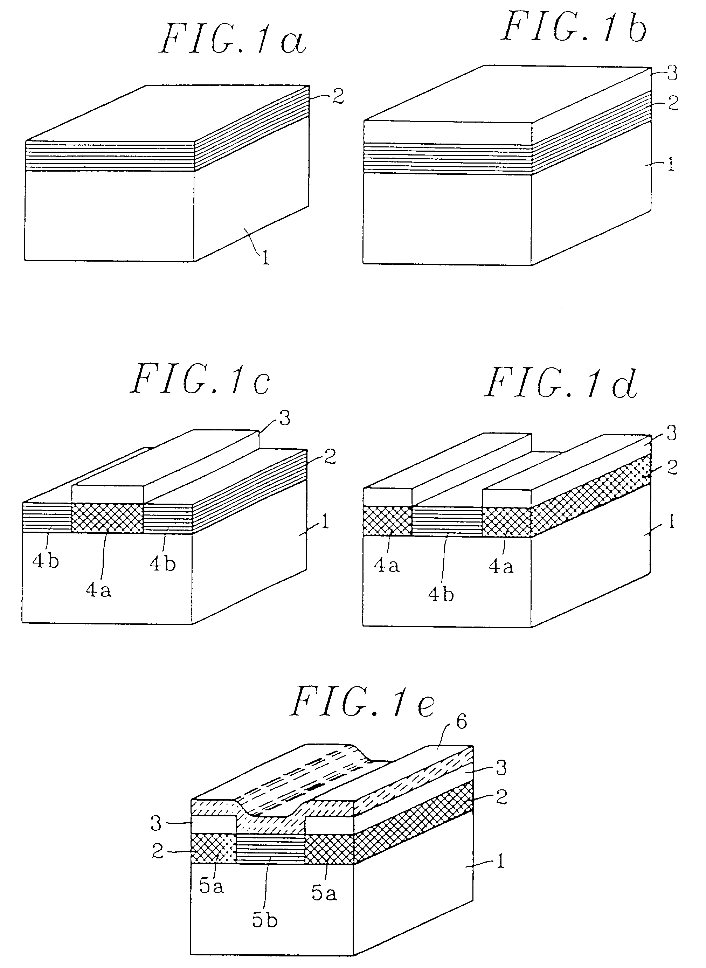

Une fois la croissance des couches à puits quantiques 2 sur le substrat 1, obtenue par des techniques classiques (figure 1a), on dépose sur les couches à puits quantiques 2 une couche 3 en un matériau diélectrique dopé (figure 1b).

Conformément à l'invention, la nature et le degré du dopage de la couche diélectrique 3, ainsi que son épaisseur sont choisis, ainsi que cela est expliqué plus loin plus en détails, de façon à contrôler l'activation ou le blocage de la transformation des couches à puits quantiques lors des traitements thermiques ultérieurs.

Le dépôt est par exemple un dépôt chimique assisté par plasma. Les techniques conventionnelles de photolithographie et de gravure permettent d'obtenir les géométries de dépôt souhaitées.

Une fois le dépôt réalisé, on traite thermiquement l'échantillon ainsi obtenu en le soumettant à une température de recuit donnée, pendant une durée determinée, en fonction du décalage d'énergie de bande interdite que l'on souhaite obtenir.

Les deux types de recuit employés sont le recuit rapide par lampes halogènes et le recuit conventionnel ou classique par effet joule. Le recuit rapide se caractérise par des temps de montée en température très courts, de l'ordre de 10 secondes pour atteindre 850°C (soit environ 100°C/s) et des paliers en température de traitement thermique de 0 à quelques dizaines de secondes. Le recuit conventionnel présente des temps de montée de l'ordre de 5 minutes et des durées de paliers de 0 à plusieurs dizaines de minutes.

Les recuits sont réalisés en tubes ouverts (et non scellés) sous un flux d'argon avec 10 % d'hydrogène.

Ainsi qu'on l'a illustré sur les figures 1c et 1d correspondant à deux géométries de dépot particulières, il apparaît des décalages d'énergie de bande interdite dans les régions des couches à puits quantiques 2 sur lesquelles la couche 3 a été déposée (régions 4a), les autres régions (régions 4b) conservant leurs propriétés initiales.

Le matériau diélectrique de la couche 3 est avantageusement SiOx contenant un dopant volontairement introduit.

Le dopage de la couche diélectrique SiOx est par exemple réalisé par l'introduction d'un élément (ou dopant) isoélectronique, c'est-à-dire un élément appartenant à la colonne III, tel que le bore (B), l'aluminium (Al), l'indium (In), le gallium (Ga) ou à la colonne V, tel que le phosphore (P), l'arsenic (As), l'azote (N), pour obtenir la transformation sans l'introduction de porteurs libres dans l'hétérostructure à puits quantiques. Si on désire obtenir des régions transformées avec la présence de porteurs libres, alors on réalise un dopage supplémentaire du dépôt diélectrique par un élément ou dopant électriquement actif tel que le silicium (Si, colonne IV) ou le soufre (S, colonne VI) comme dopant donneur de type n, ou tel que le zinc (Zn, colonne II) ou le magnésium (Mg, colonne II) comme dopant accepteur de type p.

Après traitement thermique, le procédé peut être complété par une étape de finalisation du composant par reprise d'épitaxie classique.

On a illustré sur la figure 1e une mise en oeuvre possible du procédé selon l'invention permettant de réaliser, sur un même support à puits quantiques, plusieurs régions 5a et 5b juxtaposées bloquées ou non présentant des décalages d'énergie de bande interdite différents. Conformément à cette mise en oeuvre, on dépose, sur une ou plusieurs régions de l'hétérostructure (régions 5a), une première couche diélectrique 3. On recouvre cette couche diélectrique 3, ainsi que d'autres régions de l'hétérostructure qui ne sont pas recouvertes par cette première couche diélectrique 3 (région 5b) par une deuxième couche diélectrique 6, puis l'on traite thermiquement l'ensemble. Les matériaux, les épaisseurs et les dopages respectifs des couches diélectriques 3 et 6 sont choisis en fonction des décalages d'énergie de bande interdite souhaités pour respectivement les régions 5a et 5b. En particulier, l'une de ces couches diélectriques pourra être choisie pour bloquer la transformation de la région de l'hétérostructure sur laquelle elle est déposée. Un exemple de diélectrique bloquant est simplement SiOx non dopé ou contenant un isoélectronique tel que l'azote (N).

En variante et de façon avantageuse, on peut également réaliser un premier dépôt diélectrique recuit et attaqué de façon à être enlevé localement, suivi d'un deuxième recuit et d'une nouvelle attaque locale, ces étapes étant renouvelées de façon à obtenir de manière contrôlée des degrés différents de transformation localisée sur un même support à puits quantiques.

Comme on l'aura compris, ce procédé permet de façon générale d'élaborer différentes fonctions électro-optiques et/ou photoniques discrètes ou intégrées sur un même support à multipuits quantiques. On peut en particulier réaliser des composants à laser enterrés, des guides d'ondes, des pixellisations pour composants photoniques à cavité verticale, des composants à laser-modulateur-guide intégrés, des lasers à émissions multiples, des coupleurs, des zones d'injection électroniques (type n ou type p) à hétérojonction latérale pour des composants électroniques à cavité verticale ou pour des transistors bipolaires latéraux.

On va maintenant illustrer la dépendance du décalage d'énergie de bande interdite obtenu en fonction du traitement thermique réalisé, ainsi que du niveau de dopage et de l'épaisseur de la couche diélectrique sur différents types d'hétérostructures à puits quantiques.

On a représenté sur les figures 2a à 2d le décalage de bande d'énergie interdite obtenu pour quatre types principaux de puits quantiques, après un traitement thermique à 850°C, en fonction de la racine carrée de la durée du traitement thermique. Dans tous les cas, la couche diélectrique déposée est une couche de SiOx présentant un dopage de phosphore à une concentration de 3.10²¹ cm-³ et une épaisseur de l'ordre de 200 nm. Le décalage en énergie est porté en ordonnées et est donné en milliélectrovolts. La racine carrée du temps de recuit du traitement thermique est porté en abscisse et est donné en min^{1/2} ou en s^{1/2}.

L'exemple de la figure 2a correspond à une hétérostructure à multipuits quantiques GaAs/GaAlAs (GaAs/Ga_{0.65}Al_{0.35}As) déposée sur un substrat de GaAs, les puits et barrières quantiques étant respectivement de 7.8 nanomètres et 8.4 nanomètres d'épaisseur, l'hétérostructure comportant 40 empilements élémentaires ou périodes.

L'exemple de la figure 2b correspond à une hétérostructure à multipuits quantiques InGaAs/InAlAs (In_{0.53}Ga_{0.47}As/In_{0.52}Al_{0.48}As), déposée sur un substrat d'InP, les épaisseurs des puits et barrières quantiques étant de 5 nanomètres, l'hétérostructure présentant 50 empilements élémentaires ou périodes.

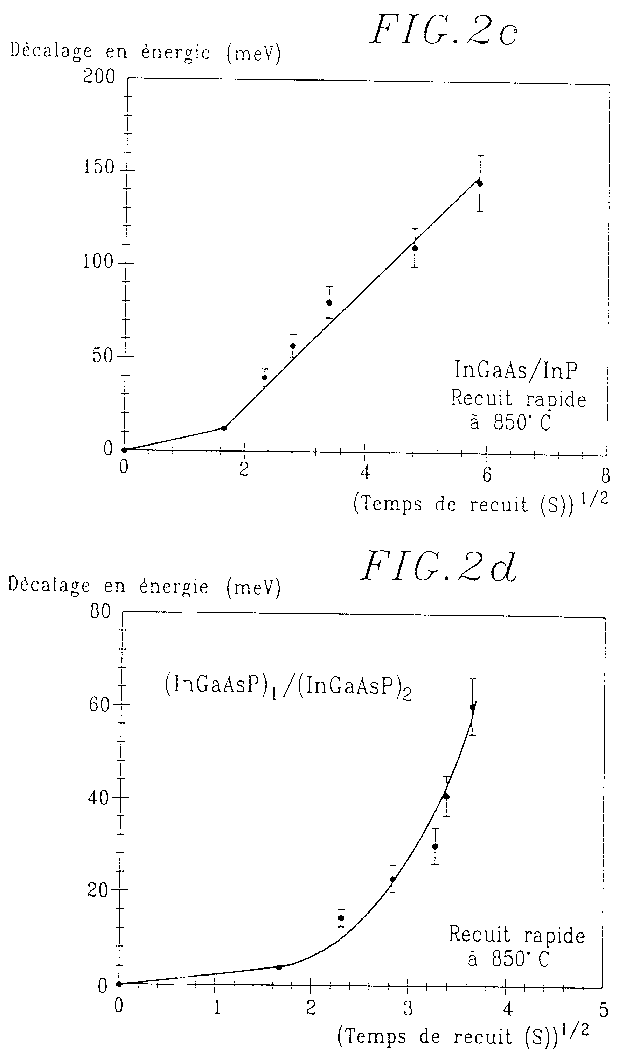

L'exemple de la figure 2c correspond à une hétérostructure à puits quantiques InGaAs/InP (In_{0,53}Ga_{0,47}/InP), déposée sur un substrat d'InP, avec des épaisseurs de puits et de barrières quantiques de 9.5 nanomètres, l'hétérostructure présentant 20 empilements élémentaires.

L'exemple de la figure 2d correspond à une hétérostructure à multipuits quantiques (InGaAsP)₁/(InGaAsP)₂ de respectivement 8 et 18 nanomètres d'épaisseur, déposée sur un substrat InP, l'hétérostructure présentant 5 empilements élémentaires.

En se servant par exemple de graphes du type de ceux des figures 2a à 2d comme courbes de référence du support testé, on contrôle, pour un dépôt diélectrique de dopage et d'épaisseur donnés, et une température de traitement thermique également donnée, le décalage en énergie de bande interdite en jouant sur la durée du traitement thermique.

Le décalage d'énergie de bande interdite est également contrôlé par l'épaisseur du dépôt diélectrique. On a représenté sur la figure 3, le décalage mesuré pour l'hétérostructure de la figure 2a, en fonction de l'épaisseur du dépôt diélectrique, dans le cas d'un traitement thermique par recuit conventionnel à 850°C. Le matériau diélectrique et le dopage de celui-ci sont identiques à ceux utilisés pour établir le graphe de la figure 2a.

En se servant par exemple de ce type de graphe comme abaque, on contrôle, pour un dépôt diélectrique de dopage donné, et une température et une durée de traitement thermique également données, le décalage en énergie de bande interdite réalisé en jouant sur l'épaisseur du dépôt diélectrique.

On se réfère maintenant à la figure 4, qui illustre la dépendance de décalage d'énergie de bande interdite en fonction de la concentration du dopant de la couche diélectrique. L'hétérostructure testée comprend 5 empilements élémentaires InGaAs (4,5 nanomètres)/InGaAsP (21 nanomètres). Le matériau diélectrique et l'élément de dopage sont les mêmes que ceux utilisés pour établir les graphes des figures précédentes. Le traitement thermique est un recuit rapide à 850°C.

On voit sur cette figure 4 que le décalage en énergie de bande interdite croît avec la concentration du dopant. Conformément au procédé selon l'invention, on contrôle le décalage en énergie de bande interdite que l'on réalise, en ajustant la concentration du dopant, par exemple en utilisant un graphe du type de celui de figure 4 correspondant à la structure testée.

On se réfère maintenant à la figure 5 sur laquelle a été représenté schématiquement un composant 10 monolithique sur lequel deux fonctions actives ont été intégrées. Ce composant 10 comporte en particulier sur un même substrat 11 une zone active 12 réalisant une fonction d'émission laser et une zone active 13 ayant une fonction de modulateur électro-optique.

Le substrat 11 est un substrat d'InP.

La structure traitée par le procédé conforme à l'invention est constituée d'une couche 14 de 5 empilements élementaires (InGaAsP)₁ (8 nanomètres) /(InGaAsP)₂ (18 nanomètres) déposés sur une couche 15 de 1,1 µm d'InGaAsP de cavité optique de confinement que porte le substrat 11. Une couche 16 de confinement similaire à la couche 15 est déposée sur la couche 14 après traitement selon le procédé conforme à l'invention.

Pour réaliser la fonction modulateur 13, on dépose sur la partie de la couche 14, qui correspond audit modulateur 13 (partie 14a), une couche activante de SiOx dopé, tandis que l'autre partie 14b de la couche 14 est recouverte d'une couche bloquante de SiO2 non dopé. Le dopage de SiOx est réalisé par l'introduction de phosphore, avec une concentration de 3 x 10²¹ cm-³. On traite thermiquement l'échantillon ainsi obtenu à 850°, pendant une durée de 7s.

A l'issue de ce traitement thermique, on dépose les couches 17, puis on réalise, en utilisant des technologies classiques pour l'Homme du Métier, un réseau 21 du laser D.F.B. (Distributed FeedBack laser). Le composant est ensuite finalisé par reprise d'épitaxie avec des couches 18 d'InP et de contact 19 d'InGaAs dopées p. La séparation ou isolation électrique 20 des couches de contact du modulateur 13 et du laser 12 est réalisée par un bombardement de protons dans la couche 18.

Les caractéristiques des fonctions laser et modulateur du composant ainsi obtenu ont été testées.

On voit sur la figure 6, sur laquelle ont été portées les courbes d'intensité de photocourant avant et après traitement thermique de la région transformée 14a, que l'hétérostructure conserve son caractère excitonique: la région 14a transformée présente un front d'absorption abrupte à 0,830 eV, propriété nécessaire pour permettre le fonctionnement optimal du modulateur.

Le front d'absorption excitonique de la région non transformée correspond à une longueur d'onde d'émission laser de 1,5507 µm (figure 7).

On a également représenté sur la figure 8, la puissance lumineuse (mW) en sortie du modulateur 13 en fonction du courant de commande du laser 12, pour différentes tensions inverses appliquées audit modulateur 13. Le courant de seuil du laser n'est pas affecté et reste faible (15 milliampères).

Les mesures de transmission optique en fonction de la tension inverse appliquée au modulateur 13 ont été portées sur la figure 9 et donnent un taux d'extinction de 15 dB pour une tension de 4 volts.

Ainsi qu'on l'aura compris, l'invention permet de simplifier l'intégration monolithique de composants électro-optiques et photoniques. Le procédé proposé par l'invention permet cette intégration, de manière "planar", reproductible et contrôlée, sur tous les types de supports à puits quantiques (contraint(s) ou non) à base de matériaux III/V.

L'invention présente l'avantage important de permettre le contrôle de la transformation du support à puits quantiques, dans une large gamme de décalage en énergie permettant la réalisation de composants actifs (décalage modéré) et passifs (décalage important) ainsi que leurs combinaisons. Elle permet la conservation des propriétés cristallines et optiques du support transformé.

## Revendications

1. Procédé pour la réalisation d'un composant présentant au moins une fonction électro-optique et/ou photonique intégrée, dans lequel on dépose au moins une couche diélectrique (3) sur une couche à puits quantiques (2) à base de matériaux III/V et on traite thermiquement l'échantillon ainsi obtenu,
caractérisé en ce que la couche diélectrique (3) est une couche de SiOx dopée, x étant compris dans l'intervalle ]0,2], et
en ce qu'on choisit l'épaisseur de ladite couche (3), la nature et la concentration de son dopage, ainsi que les conditions du traitement thermique, de façon à décaler l'énergie de bande interdite de la région (4a ; 5a, 5b) de la couche à puits quantiques (2) sur laquelle la couche diélectrique (3) est déposée pour conférer à cette région (4a ; 5a, 5b) les propriétés électro-optiques et/ou photoniques correspondant à ladite fonction.

2. Procédé selon la revendication 1, caractérisé en ce que la couche à puits quantiques (2) est du type à base de GaAs et d'InP.

3. Procédé selon la revendication 2, caractérisé en ce que la couche à puits quantiques (2) est du type GaAs/GaAlAs, ou InGaAs/Ga(Al)As ou InGaAs/InAlAs ou InGaAs/InP ou InGaAs(P)/InGaAsP.

4. Procédé selon l'une des revendications précédentes, caractérisé en ce que le dopage de la couche diélectrique (3) est isoélectronique.

5. Procédé selon la revendication 4, caractérisé en ce que le dopage isoélectronique de la couche diélectrique (3) est complété par un dopage supplémentaire de type n.

6. Procédé selon la revendication 4, caractérisé en ce que le dopage isoélectronique de la couche diélectrique (3) est complété par un dopage supplémentaire de type p.

7. Procédé selon l'une des revendications précédentes, caractérisé en ce qu'on dépose sur au moins deux régions (5a, 5b) de la couche (2) à puits quantiques des couches diélectriques
- que l'on traite thermiquement de façon différente et/ou
- qui sont de matériau et/ou d'épaisseur et/ou de dopage différent(s).

8. Procédé selon la revendication 7, caractérisé en ce que l'une au moins de ces deux couches diélectriques (3, 6) bloque la transformation de la région sur laquelle elle est déposée.

9. Procédé selon la revendication 8, caractérisé en ce que la couche qui bloque la transformation de la région sur laquelle elle est déposée est un couche de SiO2 non dopée, ou dopée avec de l'azote.

10. Procédé selon l'une des revendications 7 à 9, caractérisé en ce qu'il comporte les différentes étapes suivantes :
- dépôt d'une couche diélectrique,
- attaque locale de la couche diélectrique,
- traitement thermique contrôlé,
et en ce qu'on renouvelle une ou plusieurs fois ces étapes de façon à obtenir des degrés différents de transformation localisée sur la couche à puits quantiques.

11. Procédé selon l'une des revendications 7 à 10 pour la réalisation d'un composant monolithique(10) présentant plusieurs fonctions électro-optiques et/ou photoniques intégrées.
